# FASCICULE DE BREVET EUROPEEN

(11) **EP 2 351 214 B1**
(45) Date de publication et mention de la délivrance du brevet: **04.04.2018**
(21) Numéro de dépôt: 09768150.6
(22) Date de dépôt: 05.11.2009
(51) Int. Cl.: H03H 9/02, H03H 9/54, H03H 9/56

(54) **ELEMENTS DE FILTRES PAR COUPLAGE TRANSVERSE SUR STRUCTURES RESONANTES A ONDES DE VOLUME A RESONANCES HARMONIQUES MULTIPLES**
TRANSVERSAL GEKOPPELTE FILTERELEMENTE AUF VOLUMENWELLENRESONANZSTRUKTUREN MIT MEHRFACHEN HARMONISCHEN RESONANZEN
TRANSVERSALLY COUPLED FILTER ELEMENTS ON BULK ACOUSTIC WAVE RESONANCE STRUCTURES WITH MULTIPLE HARMONIC RESONANCES.

(30) Priorité: 05.11.2008 FR 0857517
(43) Date de publication de la demande: 03.08.2011
(73) Titulaire: Centre National de la Recherche Scientifique (C.N.R.S.), 75016 Paris (FR); Université de Franche-Comté, 25030 Besançon Cedex (FR)
(72) Inventeur: GACHON, Dorian, F-66750 ST CYPRIEN (FR); BALLANDRAS, Sylvain, F-25000 Besancon (FR)
(74) Mandataire: Lavoix
(86) Numéro de dépôt international: PCT/FR2009/052138
(87) Numéro de publication internationale: WO 2010/052433

(56) Documents cités:
- DE-A1- 10 319 554
- DORIAN GACHON ET AL: "Frequency sources and filters applications using high overtone bulk acoustic resonators exhibiting high Q.f product" FREQUENCY CONTROL SYMPOSIUM, 2008 IEEE INTERNATIONAL, IEEE, PISCATAWAY, NJ, USA, 19 mai 2008 (2008-05-19), pages 783-788, XP031319975 ISBN: 978-1-4244-1794-0
- PIJOLAT, M.; REINHARDT, A.; DEFAY, E.; DEGUET, C.; MERCIER, D.; AID, M.; MOULET, J.S.; GHYSELEN, B.; GACHON, D.; BALLANDRAS, S.: "Large Qxf Product for HBAR using Smart Cut TM transfer of LiNbO3 thin layers onto LiNbO3 substrate" ULTRASONICS SYMPOSIUM, 2008. IUS 2008. IEEE, 3 novembre 2008 (2008-11-03), XP002534288 DOI: 10.1109/ULTSYM.2008.0049
- UNO T: "A proposal of a bulk acoustic wave filter using piezoelectrically coupled resonators" ULTRASONICS SYMPOSIUM, 1994. PROCEEDINGS., 1994 IEEE CANNES, FRANCE 1-4 NOV. 1994, NEW YORK, NY, USA,IEEE, US, vol. 2, 1 novembre 1994 (1994-11-01), pages 945-948, XP010139672 ISBN: 978-0-7803-2012-3
- LAKIN K M ET AL: "High Q microwave acoustic resonators and filters" MICROWAVE SYMPOSIUM DIGEST, 1993., IEEE MTT-S INTERNATIONAL ATLANTA, GA, USA 14-18 JUNE 1993, NEW YORK, NY, USA,IEEE, US, 14 juin 1993 (1993-06-14), pages 1517-1520, XP010068312 ISBN: 978-0-7803-1209-8

## Description

L'invention se rapporte à un filtre élémentaire de type à ondes de volumes à modes harmoniques élevés HBAR (en anglais Harmonic Bulk Acoustic Resonator) destiné à former des filtres plus complexes et un procédé de fabrication correspondant.

L'Article DORIAN GACHON ET AL: "Frequency sources and filters applications using high overtone bulk acoustic resonators exhibiting high Q.f product", FREQUENCY CONTROL SYMPOSIUM, 2008 IEEE, 19 mai 2008, pages 783-788, XP031319975, ISBN: 978-1 -4244-1794-0 décrit un résonateur HBAR réalisé par report et amincissement de plaques monocristallines sur différents substrats. Cet article mentionne la possibilité de fabriquer des filtres en échelle à partir de ce type de résonateur. Un filtre à échelle est une combinaison électrique de résonateurs.

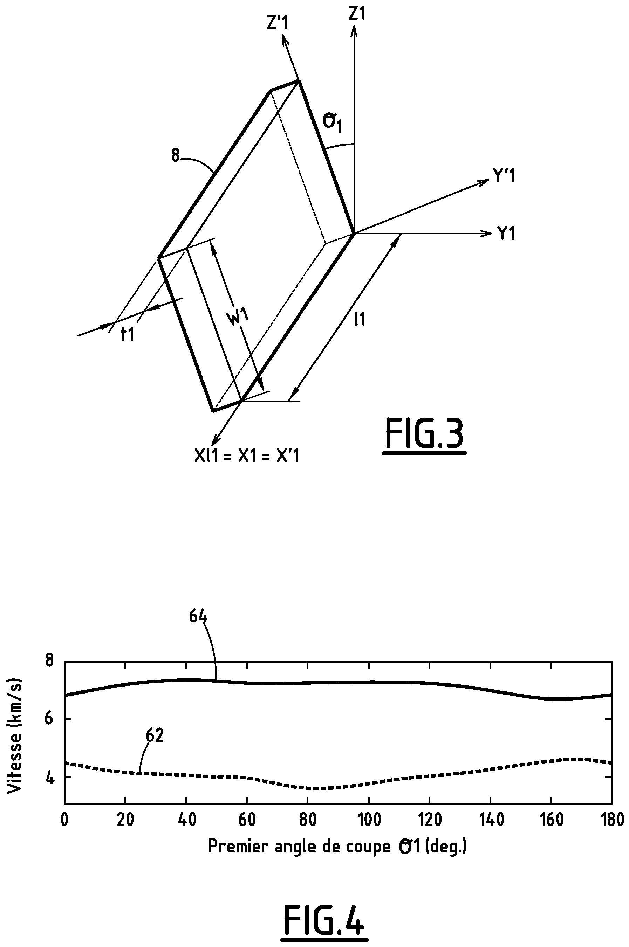

L'article PIJOLAT, M. ET AL.: "Large Qxf Product for HBAR using Smart Cut TM transfer of LiNb03 thin layers onto LiNb03 substrate", ULTRASONICS SYMPOSIUM, 2008. IUS 2008. IEEE, 3 novembre 2008 (2008-11-03),XPOO2534288, DOI: 10.1109/ULTSYM.2008.0049 décrit un procédé de fabrication d'un résonateur HBAR. Si la figure 3 de cet article est assimilée à deux résonateurs couplés pour constituer un filtre, ce couplage est électrique.

Le principe pour réaliser un filtre consistant à coupler au moyen d'une zone intermédiaire étroite deux résonateurs électroacoustiques identiques à ondes de volume, chacun étant constitué d'un transducteur électroacoustique enserré entre deux électrodes, est connu. La zone intermédiaire du transducteur est suffisamment étroite de sorte que se produise un recouvrement des d'ondes évanescentes des champs émis par les deux résonateurs, créant ainsi des conditions de couplage entre les résonances des deux résonateurs. Ces conditions de couplage permettent de transmettre des informations entre des points d'entrée et des points de sortie de la structure du filtre dans une zone spectrale d'autant plus grande que les modes sont couplés c'est-à-dire que la zone intermédiaire de séparation entre les deux résonateurs est étroite.

Ce principe a été développé pour des filtres de fréquence fonctionnant dans la gamme de fréquences comprise entre 1 et 30 MHz à l'aide de résonateurs à ondes de volume classiques, c'est-à-dire exploitant le mode fondamental d'une lame de matériau monocristallin, typiquement du quartz, ou céramique piézoélectriques pour réaliser un tel couplage.

Toutefois, la montée vers des fréquences plus élevées semble délicate du fait de l'amincissement des plaques dans cette perspective menant à des structures fragiles de quelques dizaines de µm à quelques µm d'épaisseur et de fait peu adaptées aux techniques de fabrication industrielles.

Ce principe a été également mis en oeuvre pour des filtres à films minces de nitrure d'aluminium (AlN), mais les épaisseurs de couches elles-mêmes constituent un problème majeur dans la mesure où elles permettent peu l'existence de modes latéraux permettant de coupler efficacement l'énergie entre deux résonateurs. Le document intitulé « Simulation, conception et réalisation de filtre à ondes de volume dans des couches piézoélectriques », Thèse de l'université de Franche-Comté, Besançon, 2005 de A.Reinhart a montré qu'il était pratiquement inenvisageable de réaliser de tels filtres, hormis en favorisant un couplage forcé qui rappelle les transducteurs inter-digités utilisés pour les ondes de surface.

Le problème technique est d'augmenter l'intensité du couplage fournie par les modes latéraux des ondes générées au sein de filtres élémentaires par deux résonateurs couplés entre eux à ondes de volumes à modes harmoniques élevés (HBAR) et pouvant fonctionner à des fréquences élevées atteignant jusqu'à 20 GHz.

A cet effet l'invention a pour objet un filtre élémentaire conforme à la revendication 1.

L'invention sera mieux comprise à la lecture de la description de deux formes de réalisation qui va suivre, donnée uniquement à titre d'exemple et faite en se référant aux dessins sur lesquels :
- la figure 1 est une vue en perspective d'une première forme de réalisation d'un filtre élémentaire de type HBAR selon l'invention,
- la figure 2 est une vue d'une coupe transversale du filtre élémentaire de la figure 1 selon la ligne II-II,
- la figure 3 est une vue de la représentation du premier angle de coupe θ1 du cristal formant le transducteur piézoélectrique,
- la figure 4 est une vue de l'évolution de la vitesse de phase des ondes de volume d'un cristal de niobate de lithium en fonction de l'angle de coupe θ1, cette famille d'orientations cristallines étant généralement appelée « coupes à simple rotation »,
- la figure 5 est une vue de l'évolution des coefficients de couplage de ces mêmes ondes pour le niobate de lithium en fonction de l'angle θ1,
- la figure 6 est une représentation planaire liée à la plaque du transducteur de la polarisation des ondes correspondant à la première forme de réalisation,
- la figure 7 est une vue de la représentation du deuxième angle de coupe θ2 du cristal formant le substrat acoustique,
- la figure 8 est une représentation planaire liée à la plaque du substrat acoustique de la polarisation des ondes correspondant à la première forme de réalisation,
- la figure 9 est une représentation graphique de la fonction de transfert large bande du filtre selon la première forme de réalisation,
- la figure 10 est une vue agrandie d'une zone de la représentation graphique de la figure 9,
- la figure 11 est une vue en perspective d'une deuxième forme de réalisation d'un filtre élémentaire de type HBAR selon l'invention correspondant à un couplage d'ondes de cisaillement,
- la figure 12 est une vue d'une coupe transversale du filtre élémentaire de la figure 11 selon la ligne XI-XI,
- la figure 13 est une représentation planaire liée à la plaque du transducteur de la polarisation des ondes correspondant à la deuxième forme de réalisation,
- la figure 14 est une représentation planaire liée à la plaque du substrat acoustique de la polarisation des ondes correspondant à la deuxième forme de réalisation,
- la figure 15 est une représentation graphique de la fonction de transfert large bande du filtre selon la deuxième forme de réalisation au voisinage de 1.24 GHz,
- la figure 16 est une vue agrandie d'une zone de la représentation graphique de la figure 15,
- la figure 17 est ordinogramme d'un mode de mise en oeuvre de fabrication du filtre élémentaire décrit aux figures 1, 2, 11 et 12.

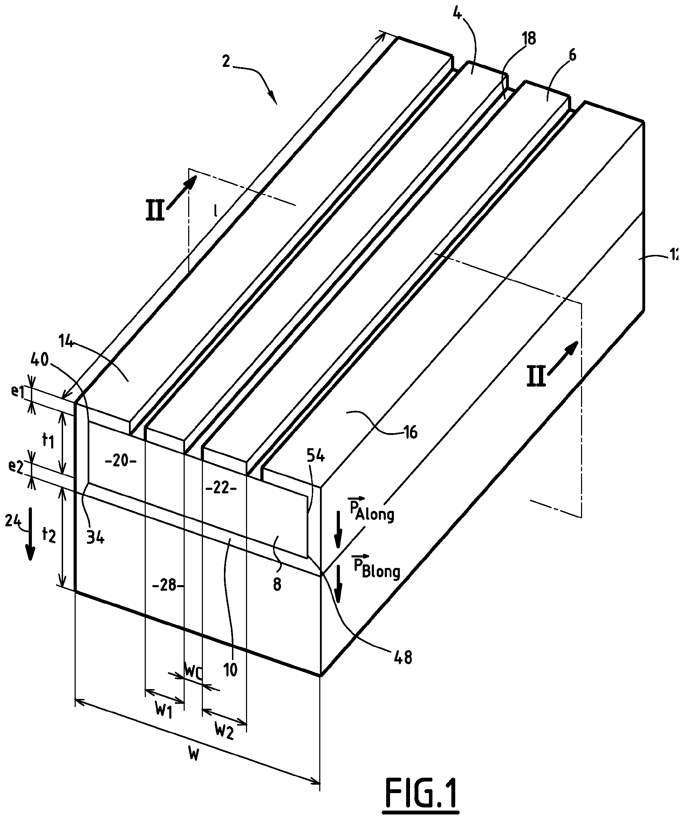

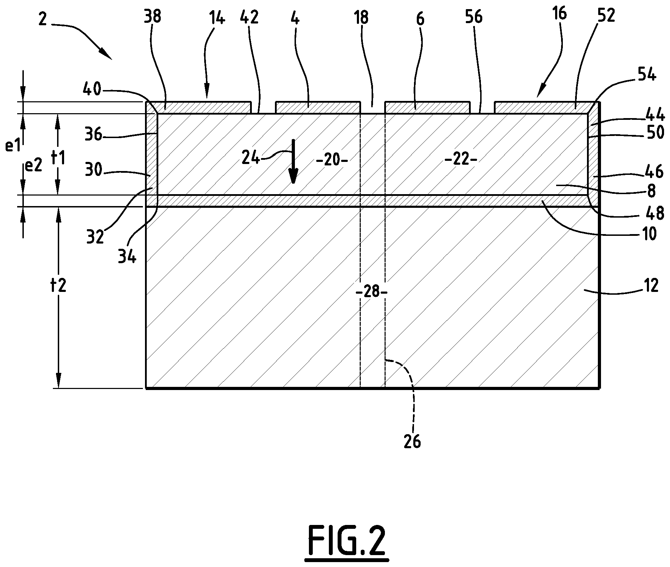

Les figures 1 et 2 représentent un premier mode de réalisation d'un filtre élémentaire 2 de type à ondes de volume à harmoniques élevées selon l'invention.

Le filtre élémentaire 2 comprend un empilement de couches successives comportant :
- une première électrode supérieure 4 et une deuxième électrode supérieure 6 d'excitation électrique, disposées côte à côte, en aluminium d'épaisseur e₁,
- un transducteur piézoélectrique 8 monobloc constitué d'un premier matériau, ici du niobate de lithium (LiNbO3), sous forme monocristalline ayant une première épaisseur t₁,
- une contre-électrode 10 d'un seul tenant, formant une électrode de référence commune vis-à-vis des électrodes 4 et 6, de forme ici parallélépipédique, en or, enterrée, et d'épaisseur e₂,
- un substrat acoustique 12 monobloc constitué d'un deuxième matériau, ici du niobate de lithium (LiNbO3) sous forme monocristalline ayant une deuxième épaisseur t₂.

Le filtre 2 comprend également un premier élément de connexion 14, respectivement un deuxième élément de connexion 16, raccordés à la contre électrode 10 du côté de la première 4, respectivement la deuxième électrode 6 supérieure.

Toutes les couches 4, 6, 8, 10, 12 présentent sur la figure 1 la même longueur l et respectivement une largeur W1, W2, W, W, W, la longueur l étant nettement supérieure à une quelconque des largeurs W1, W2, W et aux différentes épaisseurs de couche e₁, t₁, e₂ et t₂.

Pour simplifier la figure 1, la contre-électrode 10 est représentée de surface égale à celle du transducteur piézoélectrique 6.

L'ensemble des première et deuxième électrodes 4, 6 présente une surface inférieure à celle de contre-électrode 10 enterrée.

Les première et deuxième électrodes 4, 6 sont séparées selon le sens de leur largeur respective W1 et W2 par un canal 18 de largeur WC très faible par rapport à W1 et W2.

La largeur WC du canal 18 est également faible par rapport à l'épaisseur t₁ du transducteur 8.

La surface de la première 4, respectivement la deuxième 6 électrodes supérieures est disposée en vis à vis, parallèle à la contre-électrode 10, les zones respectives en regard des surfaces étant maximales, avec des bords les plus parallèles possible.

Ainsi, l'excitation des ondes est supposée correspondre à une configuration d'un premier résonateur 20, respectivement un deuxième résonateur 22, dite plan-plan, pour laquelle les ondes sont excitées par les électrodes 4, 10, respectivement les électrodes 6, 10 très minces déposées sur les surfaces en regard du transducteur piézoélectrique 8, dans le sens représenté par la flèche 24 selon la figure 2, de propagation des ondes dans le transducteur 8.

Le premier résonateur 20 comprend la première électrode 4, et les zones des couches de même section situées en dessous à la perpendiculaire, y compris ici la couche correspondante de substrat acoustique 12.

Le deuxième résonateur 22 comprend la deuxième électrode 6, et les zones de même section des couches situées en dessous à la perpendiculaire, y compris ici la couche correspondante de substrat acoustique 12.

Ainsi, les ondes des premier et deuxième résonateurs 20, 22 sont couplées par des ondes évanescentes transversales dans une zone intermédiaire 26 du filtre 2, délimitée grossièrement par des traits pointillés sur la figure, séparant les deux résonateurs 20, 22 et formant un élément de couplage 28 entre les deux résonateurs 20, 22.

L'élément de couplage 28 comprend la partie de transducteur 8 située dans la zone intermédiaire 26 immédiatement en dessous du canal 18, et les parties de même section des autres couches situées dans la zone intermédiaire 26 en dessous du canal 18 à la perpendiculaire, y compris la couche correspondante de substrat acoustique 12.

Ainsi, l'étendue de la zone de couplage entre les deux résonateurs 20, 22 au travers de l'élément de couplage 28 est augmentée par l'adjonction du substrat acoustique 12.

Le transducteur piézoélectrique 8 présente ici un mode de vibration longitudinal excité selon une polarisation dirigée le long des épaisseurs e₁, t₁, e₂ et t₂ des deux résonateurs 16, 18, représenté par le vecteur *P̅_{Along}*.

Le substrat acoustique 12 présente ici un mode de vibration longitudinal *P̅_{Blong}*.

Sur la figure 1, le vecteur de polarisation *P̅_{Along}* de l'excitation correspondant au mode longitudinal du transducteur 8 est aligné avec le vecteur de polarisation longitudinale référencé *P̅_{Blong}* du substrat acoustique 12.

La contre-électrode 10 interposée entre le transducteur 8 et le substrat 12 sert en outre de colle à la structure du filtre comprenant les deux résonateurs 20, 22.

La couche de niobate de lithium (LiNbO₃) constituant le transducteur 8 est une plaque découpée selon un premier angle de coupe θ1 dans un matériau brut monocristallin formant une tranche dénommée wafer en anglais.

La couche de niobate de lithium constituant le substrat acoustique 12 est une plaque découpée selon un deuxième angle de coupe θ2 dans une tranche du matériau monocristallin brut.

Le premier élément de connexion 14 est ici un prolongement de la contre électrode 10 étendu du côté de la première électrode supérieure 4. Il se présente sous la forme d'un ruban 30 de largeur égale à la longueur de la contre-électrode 10 et de même épaisseur comprenant un premier tronçon 32 contournant une première arête inférieure 34 du transducteur 8 et plaqué sur le flanc 36 du transducteur 8 situé du coté de l'électrode 4, un deuxième tronçon 38 contournant une première arête supérieure 40 du transducteur 8 et plaqué partiellement sur une surface nue 42 du transducteur 8, opposée au substrat 12 et en retrait de l'électrode 4. Le premier élément de connexion 14 présente ainsi une extrémité située au même niveau que la première électrode supérieure 4.

Le deuxième élément de connexion 16 est ici un prolongement de la contre électrode 10 étendu du côté de la deuxième électrode supérieure 6. Il se présente sous la forme d'un ruban 44 de largeur égale à la longueur de la contre-électrode 10 et de même épaisseur comprenant un premier tronçon 46 contournant une deuxième arête inférieure 48 du transducteur 8 et plaqué sur le flanc 50 du transducteur 8 situé du coté de l'électrode 6, un deuxième tronçon 52 contournant une deuxième arête supérieure 54 du transducteur 8 et plaqué sur une surface nue 56 du transducteur 8 en retrait de l'électrode 6. Le deuxième élément de connexion 16 présente ainsi une extrémité située au même niveau que la deuxième électrode supérieure 6.

Le filtre élémentaire 2 est apte à être inséré dans un circuit électrique en tant qu'un premier quadripôle électrique dont deux entrées sont formées par l'électrode 4 et le premier élément de connexion 14, et deux sorties sont formées par l'électrode 6 et le deuxième élément de connexion 16, les éléments de connexion 14 et 16 étant à un même potentiel.

Il peut être également considéré comme un deuxième quadripôle électrique ayant comme entrées 6, 16 et sorties 4, 14 de fonction de transfert inverse à celle du premier quadripôle.

Selon la figure 3, la plaque du transducteur 8 est découpée selon un premier angle θ1 de coupe à partir du matériau de la tranche non représentée mais repérée par ses axes cristallographiques X₁, Y₁, Z₁, l'axe Z₁ étant l'axe longitudinal de la tranche et les axes cristallographiques X₁, Y₁ étant prédéterminés lors de la fabrication du monocristal.

L'angle θ1 est ici celui défini dans le standard IEEE Std-176 (révision 1949) comme l'angle θ1 d'une coupe à simple rotation autour de l'axe cristallographique X1, la coupe étant notée (Y₁ Xₗ₁) / θ1 dans le standard IEEE, Xₗ₁ étant l'axe aligné sur le bord inférieur droit d'épaisseur t₁ de longueur l1 selon la représentation de la figure 3.

Le repère lié à la plaque découpée 8 est représenté par les trois axes X'₁, Y'₁, Z'₁, l'axe X'₁ étant confondu avec l'axe X₁. Les deux axes Y'₁, Z'₁, sont obtenus respectivement par la rotation d'angle θ1 des axes X₁, Y₁ autour de l'axe X₁.

La figure 4 représente l'évolution de la vitesse de phase des ondes longitudinales et de cisaillement pour des coupes à simple rotation autour de l'axe cristallographique Xₗ₁ du transducteur 8, lorsqu'il est constitué de niobate de lithium.

La courbe 62 représente la vitesse de phase des ondes de cisaillement se propageant dans le transducteur 8 selon l'axe normal aux plans des électrodes 4, 6 et 10 en fonction du premier angle de coupe θ1 exprimé en degrés.

La courbe 64 représente la vitesse de phase des ondes longitudinales, exprimée en km/s, se propageant dans le transducteur 8 selon l'axe de la longueur l en fonction du premier angle θ1, exprimé en degrés.

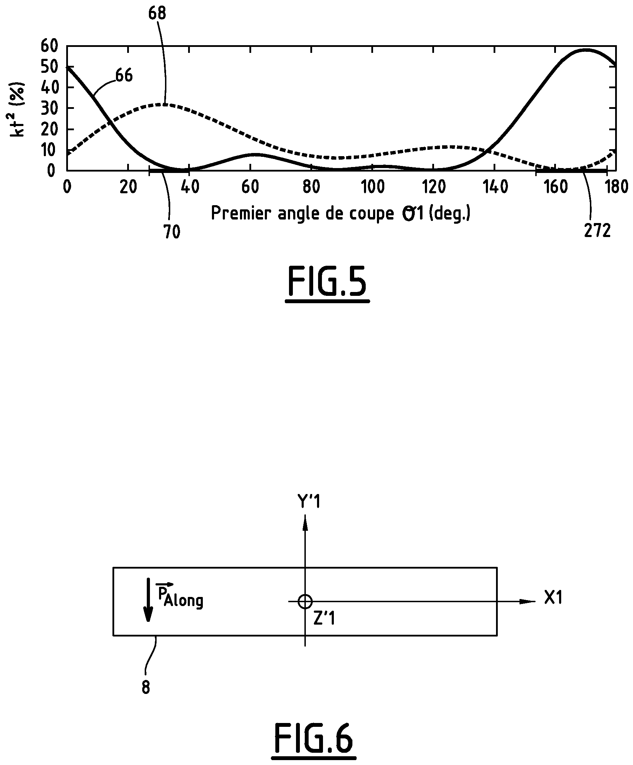

La figure 5 représente le couplage des ondes longitudinales et de cisaillement pour les coupes à simple rotation autour de l'axe cristallographique X₁ du transducteur 8 lorsqu'il constitué de niobate de lithium.

La courbe 66 représente l'évolution du coefficient de couplage K²_{T} exprimée en pourcentage d'énergie électrique convertie en énergie acoustique pour des ondes de cisaillement en fonction du premier angle de coupe θ1 exprimé en degrés.

La courbe 68 représente l'évolution du coefficient de couplage K²_{T} exprimée en pourcentage d'énergie électrique convertie en énergie acoustique pour des ondes longitudinales en fonction du premier angle de coupe θ1 exprimé en degrés.

Il est visible sur la figure 5 que les courbes 66 et 68 présentent une zone angulaire 70 dans laquelle l'onde de cisaillement n'est quasiment pas couplée par piézoélectricité et par conséquent non excitée électriquement. L'excitation de l'onde longitudinal est particulièrement efficace, avec un couplage électromécanique représenté par K²_{T} compris entre 20 et 30%.

La zone angulaire 70 est centrée autour de l'angle θ1 égal à 36 degrés et d'amplitude égale à 10 degrés.

L'angle de coupe θ1 du transducteur décrit à la figure 1 est choisi dans la zone 70 de la figure 5 centrée autour de 36 degrés.

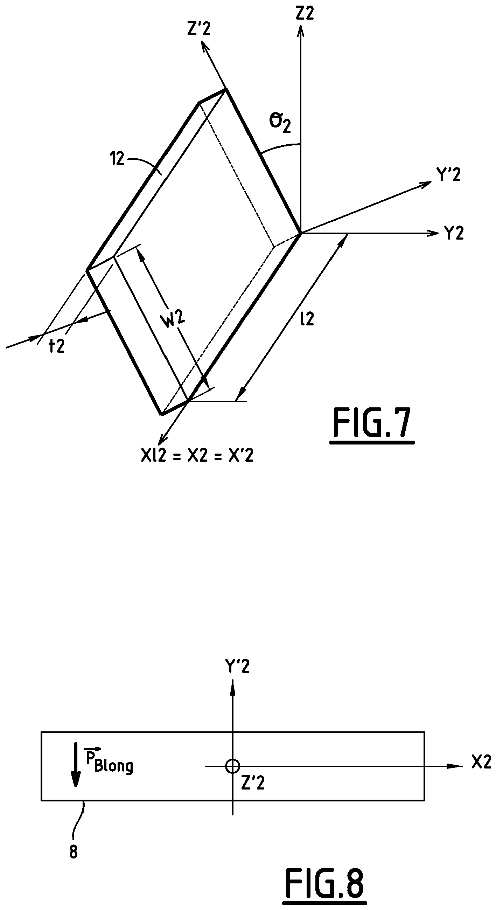

En considérant la représentation planaire fournie à la figure 6 de la plaque du transducteur 8 selon les axes planaires X'₁, Y'₁, on montre que le mode de vibration excité par piézoélectricité présente une polarisation scalaire selon l'axe Y'₁ représenté vertical sur la figure 8, c'est à dire normal au plan (X₁, Z'₁), mais dont la dépendance spatiale est décrite par une fonction des coordonnées spatiales selon le plan d'excitation. Le vecteur de polarisation *P̅_{Along}* est colinéaire à l'axe Y'₁.

Selon la figure 7, la plaque de substrat acoustique 12 est découpée selon un deuxième angle θ2 de coupe à partir du monocristal brut de la tranche non représentée mais repérée par les axes cristallographiques du quartz X₂, Y₂, Z₂, l'axe Z₂ étant l'axe optique C révélé lors de la croissance d'une gemme de cristal.

L'angle θ2 est également ici celui défini dans le standard IEEE Std-176 (révision 1949) comme l'angle θ2 d'une coupe à simple rotation autour de l'axe cristallographique X₂, la coupe étant notée (Y₂, Xₗ₂) / θ2 dans le standard IEEE Std-176, Xₗ₂ étant l'axe aligné sur le bord inférieur droit d'épaisseur t₂ de longueur l₂ selon la représentation de la figure 3.

Le repère lié à la plaque de substrat acoustique découpée 12 est représenté par les trois axes X'₂, Y'₂, Z'₂, l'axe X'₂ étant confondu avec l'axe X₂. Les deux axes Y'₂, Z'₂ sont obtenus respectivement par la rotation d'angle θ2 des axes Y₂, Z₂ autour de l'axe X₂.

En considérant la représentation planaire selon les axes X'₂, Y'₂ fournie à la figure 8 de la plaque de substrat acoustique 12, analogue à la représentation planaire fournie pour le transducteur 8 à la figure 6, on peut décrire la polarisation du mode de vibration longitudinal que l'on cherche à exploiter dans le substrat acoustique 12 qui présente des coupes pour lesquelles le produit coefficient de qualité acoustique fréquence de travail au moins égal à 5.10¹².

Le mode de vibration longitudinal du substrat acoustique 12, constitué de niobate de lithium, présente également une polarisation scalaire, et s'établit selon l'axe Y'₂ et dépend des coordonnées locales liées à la plaque selon le plan d'excitation. Pour les plaques de transducteur 8 en niobate de lithium à simple de rotation notée (YXl/θ) selon la notation standard IEEE révision 1949 (IEEE standard on piezoelectricity Std 176-1949, Proc. of the IRE, vol. 37, pages 1378-1395, 1949), les ondes longitudinales choisies ne se couplent que si les alignements des axes cristallographiques du transducteur 8 et du substrat acoustique 12 sont convenablement choisis. Il faut tenir compte de ces polarisations lors de l'assemblage des matériaux du transducteur et du substrat acoustique pour permettre le couplage des ondes acoustiques que l'on veut exciter dans le substrat acoustique 12 de propagation, ici le niobate de lithium.

Ici, cet effet de couplage acoustique est obtenu en alignant l'axe Z'₁ du transducteur 8 sur l'axe Z'₂ du substrat acoustique 12 de sorte que la polarisation *P̅_{Along}* soit identique à celles de modes de cisaillement dans la substrat acoustique 12 représenté par *P̅_{Blong}.*

La réponse du filtre 2 réalisé selon la première forme de réalisation décrite à la figure 1 a été caractérisée par des mesures en termes de fonction de transfert pour différentes bandes de fréquences correspondant aux zones spectrales de fort couplage du mode longitudinal.

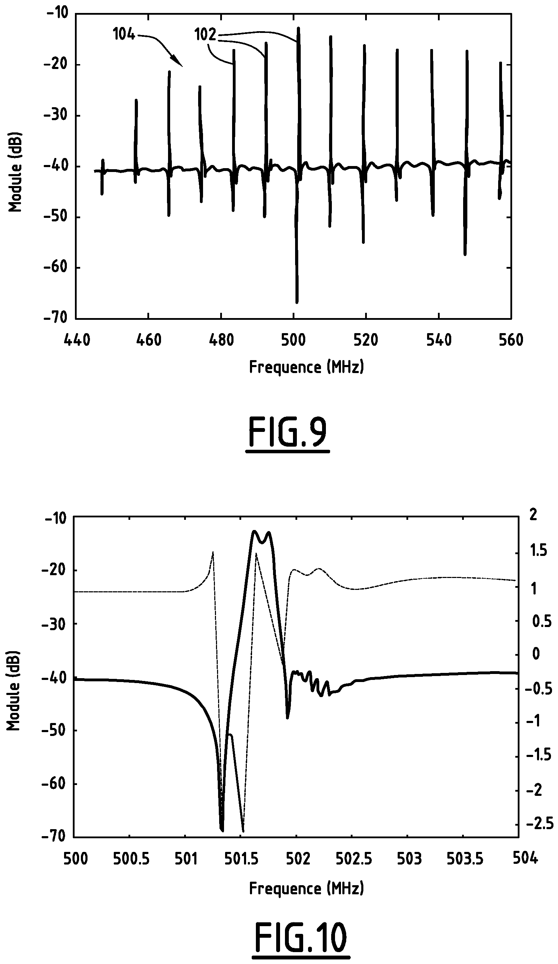

La figure 9 représente le type de réponse spectrale large bande au voisinage de l'harmonique de rang 5 du mode fondamental ici égal à 100 MHz du transducteur, c'est-à-dire au voisinage de 500 MHz. Plusieurs fonctions de filtrage 102 formant un peigne 104 sont visibles séparées de 10 MHz environ l'une de l'autre. Le rejet hors bande pour un filtre élémentaire 2 dénommé également cellule de filtrage est ici égal à 25 dB.

Les pertes d'insertion du filtre élémentaire mesurées sont ici égales à 10 dB mais peuvent être diminuées compte tenu que le filtre testé n'est pas accordé en impédance sur 50 Ω.

La figure 10 représente sous la forme d'une courbe de module en trait ininterrompu et d'une courbe de phase en traits pointillés, un agrandissement de la fonction de transfert de filtrage 102 centrée sur la fréquence de 501,1 MHz et représentée sur la figure 9.

L'agrandissement montre très nettement deux pôles distincts formant la réponse spectrale du filtre, qui prouve que le filtre fonctionne par couplage de modes de vibration, un mode symétrique où les vibrations acoustiques sont en phase dans les deux résonateurs 20, 22 et un mode antisymétrique où les vibrations acoustiques sont en opposition de phase dans les deux résonateurs 20, 22.

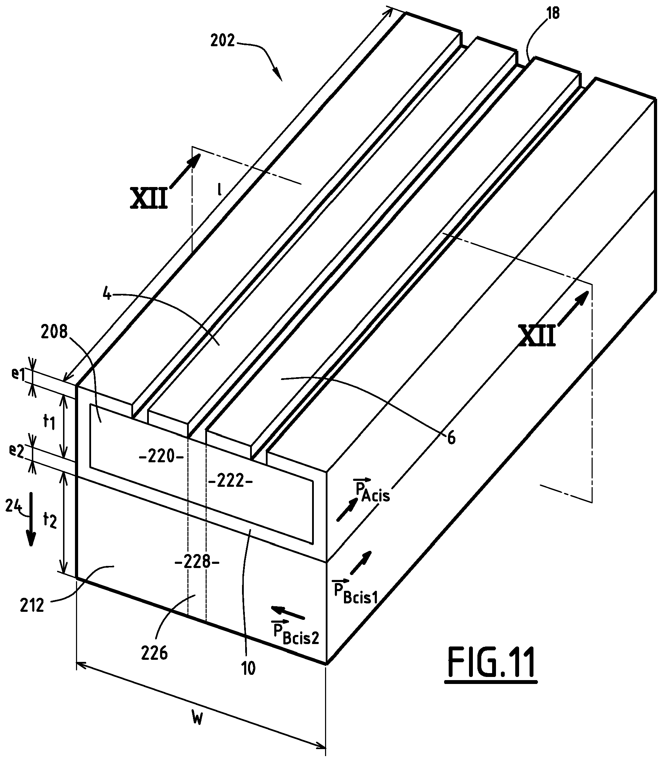

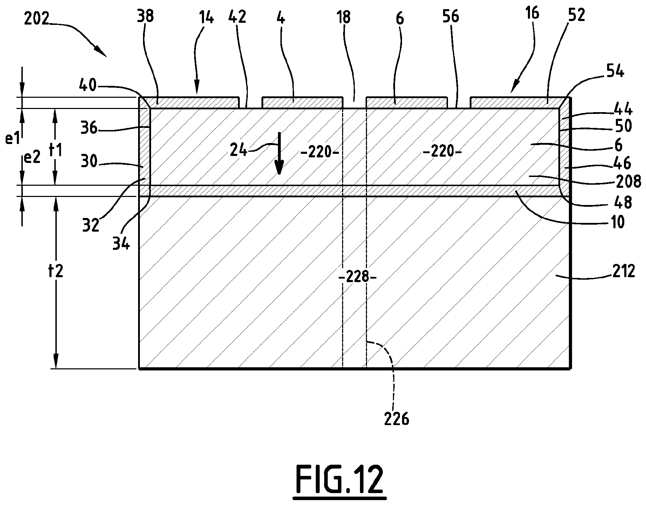

Les figures 11 et 12 représentent un deuxième mode de réalisation d'un filtre élémentaire 202 de type à ondes de volume à harmoniques élevées selon l'invention.

La structure géométrique extérieure du filtre est identique à celle du filtre de la première forme de réalisation. Les éléments identiques des figures 1, 2 et 10, 11 portent les mêmes références.

Seuls le transducteur 208 et le substrat acoustique 212 du filtre 202 diffèrent du transducteur 8 et de du substrat acoustique 12 du filtre 2 de la figure 1.

Le transducteur piézoélectrique 208 monobloc est constitué en niobate de lithium (LiNbO3) sous forme monocristalline.

Le substrat acoustique 212 monobloc est constitué de quartz sous forme monocristalline.

L'excitation des ondes est ici également supposée correspondre à une configuration d'un premier résonateur 220, respectivement un deuxième résonateur 222, dite plan-plan, pour laquelle les ondes sont excitées par les électrodes 4, 10, respectivement les électrodes 6, 10 très minces déposées sur les surfaces en regard du transducteur piézoélectrique 208, dans le sens représenté par la flèche 24 selon la figure 11 de propagation des ondes dans le transducteur 208.

Le premier résonateur 220 comprend la première électrode 4, et les zones des couches de même section situées en dessous à la perpendiculaire, y compris ici la couche correspondante de substrat acoustique 212.

Le deuxième résonateur 222 comprend la deuxième électrode 6, et les zones de même section des couches situées en dessous à la perpendiculaire, y compris ici la couche correspondante de substrat acoustique 212.

Ainsi, les ondes des premier et deuxième résonateurs 220, 222 sont couplées par des ondes évanescentes transversales dans une zone intermédiaire 226 du filtre 2 séparant les deux résonateurs 220, 222 et formant un élément de couplage 228 entre les deux résonateurs.

L'élément de couplage 228 comprend la partie de transducteur 208 située dans la zone intermédiaire 226 immédiatement en dessous du canal 18, et les parties de même section des autres couches situées dans la zone intermédiaire 226 en dessous du canal 18 à la perpendiculaire, y compris la couche correspondante de substrat acoustique 12.

Ainsi, l'étendue de la zone de couplage entre les deux résonateurs 220, 222 au travers de l'élément de couplage 228 est augmentée par l'adjonction du substrat acoustique 212.

Le transducteur piézoélectrique 208 présente un mode de cisaillement excité selon une polarisation dirigée le long de la longueur l du résonateur représenté par le vecteur *P̅_{Acis}.*

Le substrat acoustique 212 présente deux modes de cisaillement, un premier dit lent et un deuxième dit rapide.

Les ondes de cisaillement dites rapides et les ondes de cisaillement dites lentes sont définies comme des ondes de cisaillement de polarisation orthogonale, les ondes dites rapides ayant une vitesse de phase supérieure aux ondes dites lentes.

Sur la figure 11, le vecteur de polarisation *P̅_{Acis}* de l'excitation correspondant au mode de cisaillement du transducteur 208 est aligné avec un vecteur de polarisation référencé *̅P̅*̅_{*Bcis*1} correspondant au mode de cisaillement lent du substrat acoustique.

Un vecteur de polarisation correspondant à l'excitation du mode de cisaillement rapide est représenté sur la figure 1 par *̅P̅*̅_{*B*2*cis*}, orthogonal à *̅P̅*̅_{*B*1*cis*} et contenu dans un plan d'extension du substrat 212.

La contre-électrode 10 interposée entre le transducteur 208 et le substrat 212 sert en outre de colle à la structure du résonateur 2.

La couche de niobate de lithium (LiNbO3) constituant le transducteur 208 est une plaque découpée selon un premier angle de coupe θ1 dans un matériau brut monocristallin formant une tranche dénommée wafer en anglais. L'angle de coupe θ1 est défini dans le même repère que celui décrit à la figure 3.

La couche de quartz constituant le substrat acoustique 212 est une plaque découpée selon un deuxième angle de coupe θ2 dans une tranche de quartz monocristallin brut. L'angle de coupe θ2 est défini dans le même repère que celui décrit à la figure 7.

Il est visible sur la figure 5 applicable pour les coupes à simple rotation de niobate de lithium que les courbes 66 et 68 présentent une zone angulaire 272 dans laquelle l'onde longitudinale n'est quasiment pas couplée par piézoélectricité et par conséquent non excitée électriquement. L'excitation de l'onde de cisaillement est particulièrement efficace, avec un couplage électromécanique représenté par K²_{T} compris entre 50 et 60%.

La zone angulaire 272 est centrée autour de l'angle θ1 égal à 163° et d'amplitude égale à 10°.

L'angle de couple θ1 du transducteur 208 décrit à la figure 10 est choisi dans la zone 272 de la figure 5 égale à 163°.

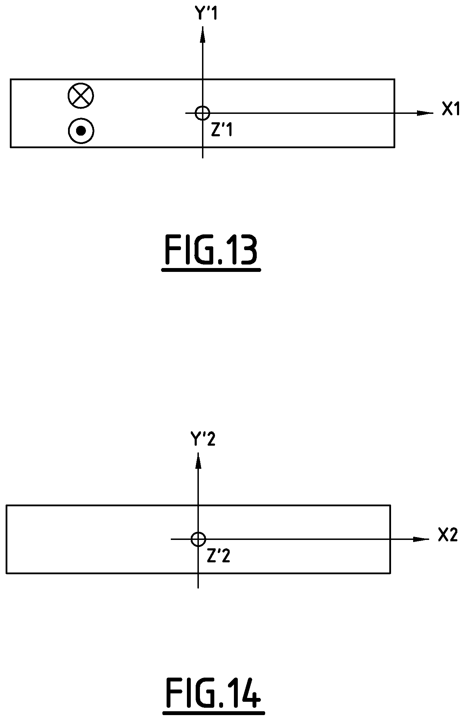

Pour les coupes de niobate de lithium à simple rotation, seul le mode correspondant à l'onde de cisaillement rapide présente un couplage électromécanique par piézoélectricité. En considérant la représentation planaire fournie à la figure 13 de la plaque du transducteur 208 selon les axes planaires X'₁, Y'₁, on montre que le mode de cisaillement excité par piézoélectricité présente une polarisation scalaire selon l'axe Z'₁ représenté de bout sur la figure 13, c'est à dire normal au plan (X'₁, Y'₁), mais dont la dépendance spatiale est décrite par une fonction des coordonnées spatiales selon le plan d'excitation. Le vecteur de polarisation *P̅_{Acis}* est colinéaire à l'axe Z'₁.

En considérant la représentation planaire selon les axes X'₂, Y'₂ fournie à la figure 14 de la plaque de quartz 212, analogue à la représentation planaire fournie pour le transducteur 208 à la figure 13, on peut décrire la polarisation du mode de cisaillement que l'on cherche à exploiter dans le quartz, par exemple qui présente des coupes pour lesquelles les sensibilités en température du premier ordre sont proches de zéro sans changer de signe. Le cisaillement du quartz est également scalaire mais s'établit selon l'axe X'₂ et dépend des coordonnées locales liées à la plaque selon le plan d'excitation. Pour les plaques de niobate ou de tantalate de lithium à simple de rotation notée (YXl/θ) selon la notation standard IEEE révision 1949 (IEEE standard on piezoelectricity Std 176-1949, Proc. of the IRE, vol. 37, pages 1378-1395, 1949), les ondes de cisaillement choisies présentent donc des polarisations orthogonales entre elles et ne se couplent que si les alignements des axes cristallographiques du transducteur 208 et du substrat acoustique 212 sont convenablement choisis. Il faut tenir compte de ces polarisations lors de l'assemblage des matériaux du transducteur 208 et du substrat acoustique 212 pour permettre le couplage des ondes acoustiques que l'on veut exciter dans le substrat acoustique 212 de propagation, ici le quartz.

Ici, cet effet de couplage acoustique est obtenu en alignant l'axe Z'₁ du transducteur 208 sur l'axe X'₂ du substrat acoustique 212, ou de manière équivalente en alignant l'axe X'₁ du transducteur 208 sur l'axe Z'₂ du substrat acoustique 212, de sorte que la polarisation *P̅_{Acis}* soit identique à celles de modes de cisaillement dans la substrat acoustique 212 représenté par *̅P̅*̅_{*B*1*cis*} permettant la compensation de la dérive thermique de la vitesse de phase des ondes correspondantes.

Dans le cas du quartz, au voisinage de l'angle de coupe θ2 égal à -24 degrés, les deux modes de cisaillement lent et rapide échangent leur polarisation. Les modes restent orthogonaux mais le mode de cisaillement rapide se substitue au mode de cisaillement lent pour les coupes d'angle θ2 compris entre -24 et -90 degrés.

Cela a pour conséquence que la représentation de la figure 11 correspond à un angle de coupe θ2 inférieur à -24 degrés, et la polarisation de vecteur *̅P̅*̅_{*B*1*cis*} correspond à un cisaillement lent d'axe X₂.

Dans le cas où l'angle de coupe θ2 est supérieur à -24 degrés, les vecteurs de polarisation *̅P̅*̅_{*B*1*cis*} et *̅P̅*̅_{*B*2*cis*} de la figure 11 sont permutés et il convient de faire tourner de 90 degrés la plaque du transducteur, c'est-à-dire le vecteur de polarisation *P̅_{Acis}* de l'onde d'excitation du transducteur, de façon à aligner les vecteur *P̅_{Acis}* sur le vecteur de polarisation *̅P̅*̅_{*B*1*cis*} de cisaillement lent, si on veut travailler à mode de cisaillement constant.

Dans la pratique, lorsque l'on cherche à stabiliser en température la fonction de transfert du filtre 202, l'angle de coupe θ2 est choisi au sein d'une zone angulaire dans laquelle le premier coefficient de température de la fréquence du premier ordre pour les ondes de cisaillement lentes est proche de zéro et s'en approche de manière douce. Cette zone angulaire est centrée autour de +35 degrés et présente une amplitude de 22 degrés garantissant ainsi un premier coefficient de température de la fréquence du premier ordre CTFB1 inférieur en valeur absolue à 20 ppm.K⁻¹

Ainsi, le premier angle de coupe l'angle θ1 du transducteur 208 de la figure 11 est choisi dans la zone 272 de la figure 5 et le deuxième angle θ2 du substrat acoustique 212 est choisi égal à environ à +35 degrés.

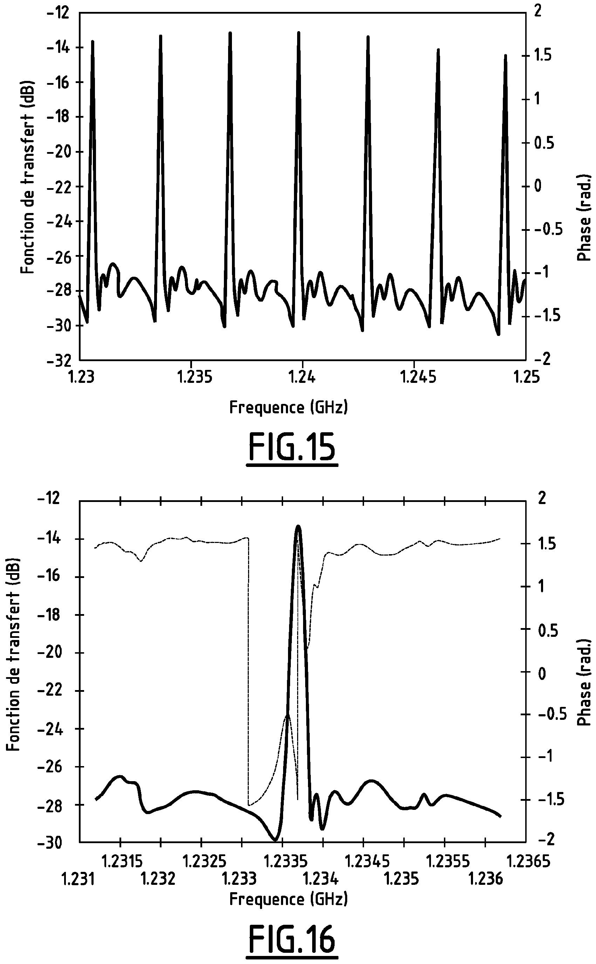

La figure 15 représente le type de réponse spectrale large bande au voisinage de l'harmonique de rang 5 du mode fondamental du transducteur c'est-à-dire au voisinage de 1,24 GHz. Plusieurs fonctions de filtrage formant un peigne sont visibles séparées de 3 MHz environ l'une de l'autre. Le rejet hors bande pour un filtre élémentaire dénommé également cellule de filtrage est égal à 16 dB.

Les pertes d'insertion du filtre élémentaire mesurées sont ici égales à 10 dB mais peuvent être diminuées compte tenu que le filtre testé n'est pas accordé en impédance sur 50 Ω.

La figure 16 représente sous la forme d'une courbe de module en trait ininterrompu et d'une courbe de phase en traits pointillés, un agrandissement de la fonction de transfert de filtrage centrée sur la fréquence de 1,2337 GHz et représentée sur la figure 15.

L'agrandissement montre très nettement deux pôles distincts formant la réponse spectrale du filtre, qui prouve que le filtre fonctionne par couplage de modes de vibration, un mode symétrique où les vibrations acoustiques sont en phase dans les deux résonateurs 220, 222 et un mode antisymétrique où les vibrations acoustiques sont en opposition de phase dans les deux résonateurs 220, 222.

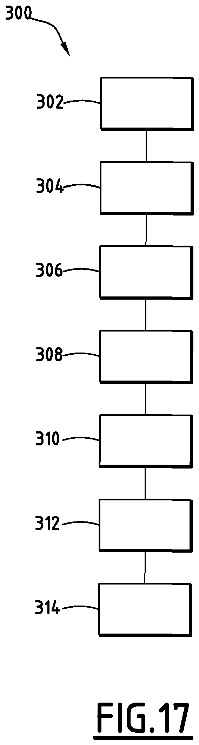

La figure 17 représente un ordinogramme d'un procédé de fabrication 300 d'un résonateur 202 décrit à la figure 11.

Dans une première étape 302, il est fourni un transducteur piézoélectrique 208 constitué par une couche d'une première épaisseur d'un premier matériau orienté selon un angle ϕ défini par la nomenclature (YXw)/ϕ du standard IEEE Std-176 (révision 1949) égal à zéro et coupé selon un premier angle de coupe θ1 défini par la nomenclature (YXl)/θ du standard IEEE Std-176 (révision 1949), tel que le couplage électroacoustique des ondes de cisaillement est supérieur à 5%.

Le matériau du transducteur 208 est choisi dans l'ensemble des matériaux constitué par le nitrure d'aluminium (AlN), l'oxyde de zinc (ZnO), le niobate de lithium (LiNbO₃), le tantalate de lithium (LiTaO₃) et le niobate de potassium.

De préférence, un matériau parmi le niobate de lithium (LiNbO3) et le tantalate de lithium (LiTaO₃) sera choisi en raison d'une maîtrise plus facile du processus de fabrication d'un monocristal d'une épaisseur significative.

Les niobate et tantalate de lithium peuvent être fabriqués par tranche de diamètre 4" selon des standards d'épaisseur de 500 µm et 350 µm.

Dans une deuxième étape 304, il est fourni un substrat acoustique 212 constitué par une couche d'une deuxième épaisseur d'un deuxième matériau ayant un produit coefficient de qualité acoustique fréquence de travail au moins égal à 5.10¹², orienté selon un angle ϕ défini par la nomenclature (YXw)/ϕ du standard IEEE Std-176 (révision 1949) égal à zéro, coupé selon un deuxième angle de coupe θ2 défini par la nomenclature (YXl)/θ du standard IEEE Std-176 (révision 1949),) et présentant au moins une direction de polarisation *̅P̅*̅_{*B*1} correspondant à un mode de vibration.

Le matériau du substrat acoustique est compris dans l'ensemble des matériaux constitué par le quartz et substituts isomorphes de type par exemple le GeO₂ et le TeO₂, l'orthophosphate de gallium (GaPO₄) également de structure isomorphe, le niobate de potassium, le tétraborate de lithium (LiB4O₇), la langasite (La₃Ga₅SiO₁₄), la langatate, la langanite et leurs différentes variantes .

De préférence, le matériau du substrat acoustique est du quartz en raison de ses remarquables propriétés de stabilité en température et de sa parfaite connaissance dans le domaine de la cristallographie.

Dans une étape suivante 306, une face du transducteur 208 et une face du substrat acoustique 212 sont métallisées selon une épaisseur comprise entre 100 à 200 nm par un métal thermo-compressible ou compressible à froid, par exemple de l'or, du cuivre ou de l'indium, en vue de coller les deux faces et de former ainsi une contre-électrode. En pratique et classiquement, une couche d'accroche typiquement du chrome ou du titane est incluse dans cette couche formant la contre-électrode à hauteur de 10% de l'épaisseur totale de la couche formant la contre-électrode.

L'or est un matériau particulièrement propice à ce genre de collage, compte tenu des ses propriétés plastiques et de sa robustesse mécanique suffisante pour assurer une liaison acoustique entre le transducteur 208 et le substrat acoustique 212.

A l'étape 308 d'assemblage, le transducteur 208 et le substrat acoustique 212 sont disposés de telle sorte que la direction de polarisation *P̅_{A}* du mode de cisaillement du transducteur 208 et la direction de polarisation *̅P̅*̅_{*B*1} de l'au moins un mode de cisaillement du substrat 212 correspondant au deuxième angle θ2 de coupe sont alignées.

Dans une étape suivante 310, le collage est effectué par compression avec élévation de température ou non selon le métal utilisé.

Dans le cas de l'utilisation de l'or, la phase de chauffage est éliminée et un pressage de longue durée est mis en oeuvre mettant à profit les qualités de surface en regard et la ductilité du matériau métallique pour assurer le collage.

Ainsi, plusieurs plaquettes composites niobate de lithium/ quartz ont pu être réalisées de cette manière sans défaut en se contentant de maintenir une température de 30° C durant les 16 heures d'application d'une pression de 3000 Newtons pour des tranches (en anglais wafers) de 3 pouces de diamètre.

Ensuite dans une étape 312, la plaquette du résonateur est rodée et polie.

Puis dans une étape 314, une première électrode 4 et une deuxième électrode 6 d'excitation électrique, distinctes entre elles, sont métallisées sur une face du transducteur 208 opposée au substrat 212 de façon à former deux résonateurs HBAR 220, 222, séparés entre eux par une zone intermédiaire 226 de couplage de l'ensemble formé par le transducteur 208, l'électrode de référence commune 10 et le substrat acoustique 212.

Les deux électrodes 4 et 6 distinctes peuvent être métallisées séparément ou être obtenues par engravure d'une électrode primaire métallisée au préalable.

Le procédé est simple à mettre en oeuvre en particulier grâce à une large plage de valeurs du deuxième angle de coupe θ2 permettant d'obtenir de bonnes performances de stabilité en température.

En outre, les résonateurs obtenus par ce procédé peuvent fonctionner jusqu'à des fréquences de 20 GHz. Les résonateurs sont légers et peu encombrants, offrant un niveau d'intégration élevée.

Un tel résonateur peut par exemple être intégré dans un oscillateur homodyne ou dans des cellules d'un filtre à réjection élevé.

Bien entendu d'autres applications peuvent être envisagées.

En variante, les étapes 302, 304 et 308 sont remplacées par des étapes similaires dans lesquelles les angles de découpe du transducteur 8 et du substrat acoustique 12 ainsi que la disposition relative du transducteur 8 et du substrat acoustique 12 sont tels qu'un couplage par ondes à modes de vibration longitudinaux est sélectionné.

En variante, le transducteur piézoélectrique (8, 208) est constitué par une couche d'une première épaisseur d'un premier matériau orienté selon un angle ϕ défini par la nomenclature (YXw)/ϕ du standard IEEE Std-176 (révision 1949) différent de zéro, coupé selon le premier angle de coupe θ1 défini par la nomenclature (YXl)/θ du standard IEEE Std-176 (révision 1949), tel que le couplage électroacoustique des ondes selon un mode longitudinal ou à cisaillement au sein de ce matériau seul est supérieur à 5%.

Dans cette variante de coupe dite à double rotation, le niveau d'excitation d'un mode du transducteur est privilégié par rapport aux deux autres modes possibles, au sens où le rapport d'amplitude entre le mode privilégié et les autres modes possibles est supérieur ou égal à 10.

## Revendications

1. Filtre élémentaire de type à ondes de volumes à modes harmoniques élevés HBAR destiné à travailler à une fréquence de travail prédéterminée, comprenant des premier (20, 220) et deuxième (22, 222) résonateurs de type HBAR et un élément de couplage (28, 228) par recouvrement d'ondes évanescentes,
le premier résonateur (20, 220), respectivement le deuxième résonateur (22, 222), comprenant une première électrode (4) d'excitation électrique, respectivement une deuxième électrode (6) d'excitation électrique, les première et deuxièmes électrodes étant distinctes et séparées par un canal (18), les premier et deuxième résonateurs partageant une même électrode de référence (10) et un même transducteur piézoélectrique (8, 208) monobloc,
l'élément de couplage (28, 228) comprenant une zone intermédiaire (26, 226) du transducteur (8, 208) disposée entre le premier et le deuxième résonateurs (20, 22 ; 220, 222),
le transducteur piézoélectrique (8, 208) étant constitué par une couche d'une première épaisseur d'un premier matériau orienté selon un angle ϕ défini par la nomenclature (YXw)/ϕ du standard IEEE Std-176 (révision 1949), coupé selon un premier angle de coupe θ1 défini par la nomenclature (YXl)/θ du standard IEEE Std-176 (révision 1949), tel que le couplage électroacoustique des ondes selon un mode longitudinal ou à cisaillement au sein de ce matériau seul est supérieur à 5%, et
**caractérisé en ce que** le premier résonateur (20, 220), le deuxième résonateur (22, 222) et l'élément de couplage (28, 228) comprennent un même substrat acoustique (12, 212) monobloc disposé en vis à vis et couplé au transducteur piézoélectrique (8, 208) au travers de l'électrode de référence (10)
le filtre fonctionnant à la fréquence de travail par couplage de modes de vibration dans les premier et deuxième résonateurs, les ondes des premier et deuxième résonateurs étant couplées par des ondes évanescentes transversales dans la zone intermédiaire, les ondes des modes de vibration dans les premier et deuxième résonateurs étant du même mode de vibration longitudinal ou de cisaillement.

2. Filtre élémentaire selon la revendication 1, **caractérisé en ce que** le substrat acoustique (12, 212) est constitué par une couche d'une deuxième épaisseur d'un deuxième matériau ayant un produit coefficient de qualité acoustique fréquence de travail au moins égal à 5.10¹², orienté selon un angle ϕ défini par la nomenclature (YXw)/ϕ du standard IEEE Std-176 (révision 1949) égal à zéro coupé selon un deuxième angle de coupe θ2 défini par la nomenclature (YXl/θ du standard IEEE Std-176 (révision 1949) et présentant au moins une direction de polarisation *̅P̅*̅_{*B*1} correspondant à un mode de vibration, et
**en ce que** la disposition relative du transducteur (8, 208) et du substrat (12, 212) est telle que la direction de polarisation du mode de vibration du transducteur (8, 208) et la direction de polarisation de l'au moins un mode de vibration du substrat (12, 212) correspondant au deuxième angle de coupe θ2 sont alignés.

3. Filtre élémentaire selon la revendication 2, **caractérisé en ce que** le rapport de l'épaisseur du substrat acoustique (12) sur l'épaisseur du transducteur (8) est supérieur ou égal à un.

4. Filtre élémentaire selon l'une des revendications 1 à 3, **caractérisé en ce que** l'angle ϕ défini par la nomenclature (YXw)/ϕ du standard IEEE Std-176 (révision 1949) est égal à zéro.

5. Filtre élémentaire selon l'une des revendications 1 à 3, **caractérisé en ce que** l'angle ϕ défini par la nomenclature (YXw)/ϕ du standard IEEE Std-176 (révision 1949) est différent de zéro.

6. Filtre élémentaire selon l'une des revendications 1 à 5, **caractérisé en ce que** le même mode de vibration des ondes est longitudinal.

7. Filtre élémentaire selon l'une des revendications 1 à 5, **caractérisé en ce que** le même mode de vibration des ondes est à cisaillement.

8. Filtre élémentaire selon l'une des revendications 1 à 7, **caractérisé en ce que** le matériau du transducteur (8, 208) est compris dans l'ensemble des matériaux constitué par le nitrure d'aluminium (AlN), l'oxyde de zinc, (ZnO), le niobate de lithium (LiNbO₃), le tantalate de lithium (LiTaO₃) et le niobate de potassium.

9. Filtre élémentaire selon la revendication 8, **caractérisé en ce que** le matériau du transducteur (8, 208) est compris de préférence dans l'ensemble des matériaux constitué par le niobate de lithium (LiNbO₃) et le tantalate de lithium (Li-TaO₃).

10. Filtre élémentaire selon l'une des revendications 1 à 9 **caractérisé en ce que** le matériau de substrat acoustique (12, 212) est compris dans l'ensemble des matériaux constitué par le quartz, le niobate de potassium, l'orthophosphate de gallium (GaPO₄), le tétraborate de lithium (LiB₄O₇), la langasite (La₃Ga₅SO₁₄), la langatate et la langanite.

11. Filtre élémentaire selon la revendication 10 **caractérisé en ce que** le matériau du substrat acoustique (12, 212) est du quartz.

12. Filtre élémentaire selon l'une des revendications 1 à 11, **caractérisé en ce que** l'électrode de référence commune (10) est constituée d'un métal thermo-compressible.

13. Filtre élémentaire selon l'une des revendications 1 à 12 **caractérisé en ce que** l'électrode de référence commune (10) est constituée d'or ou de cuivre ou d'indium.

14. Filtre élémentaire selon l'une des revendications 1 à 13 **caractérisé en ce que** l'électrode de référence commune (10) est prolongé latéralement par deux éléments de connexion (14 et 16) contournant le transducteur (8, 208) et ayant chacun une extrémité à un même niveau que les électrodes d'excitation électrique (4) et (6).

## Patentansprüche

1. Elementarer Filter des Typs mit Volumenwellen mit erhöhten harmonischen Moden HBAR, welcher dazu vorgesehen ist, mit einer vorbestimmten Arbeitsfrequenz zu arbeiten, aufweisend einen ersten (20, 220) und zweiten (22, 222) Resonator vom Typ HBAR und ein Kopplungselement (28, 228) zur Überlappung von evaneszenten Wellen,
wobei der erste Resonator (20, 220) bzw. der zweite Resonator (22, 222) eine erste Elektrode (4) zur elektrischen Anregung bzw. eine zweite Elektrode (6) zur elektrischen Anregung aufweist, wobei die erste und zweite Elektrode voneinander verschieden und mittels eines Kanals (18) getrennt sind, wobei der erste und zweite Resonator eine gemeinsame Referenzelektrode (10) und denselben einstückigen piezoelektrischen Wandler (8, 208) teilen,
wobei das Kopplungselement (28, 228) eine Zwischenzone (26, 226) des Wandlers (8, 208), welche zwischen dem ersten und dem zweiten Resonator (20, 220; 22, 222) angeordnet ist, aufweist,
wobei der piezoelektrische Wandler (8, 208) gebildet ist mittels einer Schicht von einer ersten Dicke eines ersten Materials, welches gemäß einem Winkel ϕ, der durch die Nomenklatur (YXw)/ϕ des Standards IEEE Std-176 (Fassung 1949) definiert ist, ausgerichtet ist, gemäß einem ersten Schnittwinkel θ1, der mittels der Nomenklatur (YXl)/θ des Standards IEEE Std-176 (Fassung 1949) definiert ist, geschnitten ist, so dass die elektroakustische Kopplung der Wellen gemäß einer Longitudinalmode oder Schermode innerhalb dieses Materials allein größer 5% ist, und
**gekennzeichnet dadurch, dass** der erste Resonator (20, 220), der zweite Resonator (22, 222) und das Kopplungselement (28, 228) dasselbe akustische, einstückige Substrat (12, 212) aufweisen, das durch die Referenzelektrode (10) mit dem piezoelektrischen Wandler (8, 208) verbunden und diesem gegenüberliegend angeordnet ist, wobei der Filter bei der Arbeitsfrequenz arbeitet mittels Koppelns der Schwingungsmoden in dem ersten und dem zweiten Resonator, wobei die Wellen des ersten und des zweiten Resonators mittels der evaneszenten Transversalwellen in der Zwischenzone gekoppelt sind, wobei die Wellen der Schwingungsmoden in dem ersten und dem zweiten Resonator von gleicher Longitudinal-Schwingungsmode oder Scher-Schwingungsmode sind.

2. Elementarer Filter gemäß Anspruch 1, **dadurch gekennzeichnet, dass** das akustische Substrat mittels einer Schicht von einer zweiten Dicke eines zweiten Materials, welches ein Produkt akustischer Qualitätsfaktor Arbeitsfrequenz von mindestens 5 . 10¹² aufweist, gemäß einem Winkel ϕ, der durch die Nomenklatur (YXw)/ϕ des Standards IEEE Std-176 (Fassung 1949) definiert ist, gleich Null ausgerichtet ist, gemäß einem zweiten Schnittwinkel θ2, der mittels der Nomenklatur (YXl)/θ des Standards IEEE Std-176 (Fassung 1949) definiert ist, geschnitten ist und mindestens eine Polarisationsrichtung *̅P̅*̅_{*B*1}, die mit einer Schwingungsmode korrespondiert, aufweist, und
dass die relative Anordnung des Wandlers (8, 208) und des Substrats (12, 212) derart ist, dass die Polarisationsrichtung der Schwingungsmode des Wandlers (8, 208) und die Polarisationsrichtung der mindestens einen Schwingungsmode des Substrats (12, 212), welche mit dem zweiten Schnittwinkel θ2 korrespondiert, fluchtend sind.

3. Elementarer Filter gemäß Anspruch 2, **dadurch gekennzeichnet, dass** das Verhältnis der Dicke des akustischen Substrats (12) zur Dicke des Wandlers (8) größer oder gleich Eins ist.

4. Elementarer Filter gemäß einem der Ansprüche 1 bis 3, **dadurch gekennzeichnet, dass** der Winkel ϕ, der durch die Nomenklatur (YXw)/ϕ des Standards IEEE Std-176 (Fassung 1949) definiert ist, gleich Null ist.

5. Elementarer Filter gemäß einem der Ansprüche 1 bis 3, **dadurch gekennzeichnet, dass** der Winkel ϕ, der durch die Nomenklatur (YXw)/ϕ des Standards IEEE Std-176 (Fassung 1949) definiert ist, von Null verschieden ist.

6. Elementarer Filter gemäß einem der Ansprüche 1 bis 5, **dadurch gekennzeichnet, dass** die gleiche Schwingungsmode der Wellen longitudinal ist.

7. Elementarer Filter gemäß einem der Ansprüche 1 bis 5, **dadurch gekennzeichnet, dass** die gleiche Schwingungsmode der Wellen auf Scherung ist.

8. Elementarer Filter gemäß einem der Ansprüche 1 bis 7, **dadurch gekennzeichnet, dass** das Material des Wandlers (8, 208) in der Gruppe von Materialien enthalten ist, die aus dem Aluminiumnitrid (AlN), Zinkoxid (ZnO), Lithiumniobat (LiNbO₃), Lithiumtantalat (LiTaO₃) und Kaliumniobat gebildet ist.

9. Elementarer Filter gemäß Anspruch 8, **dadurch gekennzeichnet, dass** das Material des Wandlers (8, 208) bevorzugt in der Gruppe von Materialien enthalten ist, die gebildet aus dem Lithiumniobat (LiNbO₃) und dem Lithiumtantalat (LiTaO₃) ist.

10. Elementarer Filter gemäß einem der Ansprüche 1 bis 9, **gekennzeichnet dadurch, dass** das Material des akustischen Substrats (12, 212) in der Gruppe von Materialien enthalten ist, die aus dem Quarz, Kaliumniobat, Galliumorthophosphat (GaPO₄), Lithiumtetraborat (LiB₄O₇), Langasit (La₃Ga₅SO₁₄), Langatat und Langanit gebildet ist.

11. Elementarer Filter gemäß dem Anspruch 10, **gekennzeichnet dadurch, dass** das Material des akustischen Substrats (12, 212) Quarz ist.

12. Elementarer Filter gemäß einem der Ansprüche 1 bis 11, **gekennzeichnet dadurch, dass** die gemeinsame Referenzelektrode (10) aus einem thermisch komprimierbaren Metall ausgebildet ist.

13. Elementarer Filter gemäß einem der Ansprüche 1 bis 12, **gekennzeichnet dadurch, dass** die gemeinsame Referenzelektrode (10) aus Gold oder Kupfer oder Indium ausgebildet ist.

14. Elementarer Filter gemäß einem der Ansprüche 1 bis 13, **gekennzeichnet dadurch, dass** die gemeinsame Referenzelektrode (10) mittels zwei Verbindungselementen (14 und 16) lateral verlängert ist, welche um den Wandler (8, 208) herumverlaufen und welche jeweilig ein Ende auf einer gleichen Höhe wie die Elektroden zur elektrischen Anregung (4) und (6) aufweisen.

## Claims

1. Elementary filter of the high-overtone bulck acoustic resonator - HBAR type which is intended to operate at a predetermined operating frequency and which comprises first (20, 220) and second (22, 222) resonators of the HBAR type and an element (28, 228) for coupling by overlapping evanescent waves,
the first resonator (20, 220), respectively the second resonator (22, 222), comprises a first electrical excitation electrode (4), respectively a second electrical excitation electrode (6), the first and second electrodes being distinct and separated by a channel (18), the first and second resonators sharing a same reference electrode (10) and a same monobloc piezoelectric transducer (8, 208),
the coupling element (28, 228) comprising an intermediate zone (26, 226) of the transducer (8, 208) that is arranged between the first and second resonators (20, 22; 220, 222), the piezoelectric transducer (8, 208) being constituted by a layer of a first thickness of a first material which is orientated in accordance with an angle ϕ defined by nomenclature (YXw)/ϕ of the IEEE standard Std-176 (1949 revision), and which is cut in accordance with a first cutting angle θ1 defined by nomenclature (YXl)/θ of the IEEE standard Std-176 (1949 revision), such that the electroacoustic coupling of the waves in accordance with a longitudinal mode or a transverse mode within the material alone is greater than 5%, and
**characterised in that** the first resonator (20, 220), the second resonator (22, 222) and the coupling element (28, 228) comprise the same monobloc acoustic substrate (12, 212) which is arranged facing and coupled to the piezoelectric transducer (8, 208) through the reference electrode (10), the filter operating at the operating frequency by coupling vibration modes in the first and second resonators, the waves of the first and second resonators being coupled by transverse evanescent waves in the intermediary zone, the wave of the vibration modes in the first and second resonators being the same longitudinal or shearing vibration mode.

2. Elementary filter according to claim 1, **characterised in that** the acoustic substrate (12, 212) is constituted by a layer of a second thickness of a second material which has a product coefficient of acoustic quality at the operating frequency which is at least equal to 5.10¹², and which is orientated in accordance with an angle ϕ defined by nomenclature (YXw)/ϕ of the IEEE standard Std-176 (1949 revision) as being equal to zero, cut in accordance with a second cutting angle θ2 defined by nomenclature (YXl)/θ of the IEEE standard Std-176 (1949 revision) and which has at least one polarisation direction *̅P̅*̅_{*B*1} corresponding to a vibration mode and
**in that** the relative arrangement of the transducer (8, 208) and the substrate (12, 212) is such that the polarisation direction of the vibration mode of the transducer (8, 208) and the polarisation direction of the at least one vibration mode of the substrate (12, 212) corresponding to the second cutting angle θ2 are aligned.

3. Elementary filter according to claim 2, **characterised in that** the ratio of the thickness of the acoustic substrate (12) to the thickness of the transducer (8) is greater than or equal to one.

4. Elementary filter according to any one of claims 1 to 3, **characterised in that** the angle ϕ defined by nomenclature (YXw)/ϕ of the IEEE standard Std-176 (1949 revision) is equal to zero.

5. Elementary filter according to any one of claims 1 to 3, **characterised in that** the angle ϕ defined by nomenclature (YXw)/ϕ of the IEEE standard Std-176 (1949 revision) is different from zero.

6. Elementary filter according to any one of claims 1 to 5, **characterised in that** the same vibration mode of the waves is longitudinal.

7. Elementary filter according to any one of claims 1 to 5, **characterised in that** the same vibration mode of the waves is transverse.

8. Elementary filter according to any one of claims 1 to 7, **characterised in that** the material of the transducer (8, 208) is included in the group of materials constituted by aluminium nitride (AlN), zinc oxide (ZnO), lithium niobate (LiNb0₃), lithium tantalate (LiTa0₃) and potassium niobate.

9. Elementary filter according to claim 8, **characterised in that** the material of the transducer (8, 208) is preferably included in the group of materials constituted by lithium niobate (LiNb0₃) and lithium tantalate (LiTa0₃).

10. Elementary filter according to any one of claims 1 to 9, **characterised in that** the material of the acoustic substrate (12, 212) is included in the group of materials constituted by quartz, potassium niobate, gallium orthophosphate (GaP0₄), lithium tetraborate (LiB₄O₇), langasite (La₃Ga₅SO₁₄), langatate and langanite.

11. Elementary filter according to claim 10, **characterised in that** the material of the acoustic substrate (12, 212) is quartz.

12. Elementary filter according to any one of claims 1 to 11, **characterised in that** the common reference electrode (10) is constituted by a thermocompressible metal.

13. Elementary filter according to any one of claims 1 to 12, **characterised in that** the common reference electrode (10) is constituted by gold or copper or indium.

14. Elementary filter according to any one of claims 1 to 13, **characterised in that** the common reference electrode (10) is extended laterally by way of two connection elements (14 and 16) which extend round the transducer (8, 208) and which each have an end at the same level as the electrical excitation electrodes (4) and (6).
